# EUROPEAN PATENT APPLICATION

(11) **EP 4 769 402 A1**
(43) Date of publication of application: **01.07.2026**
(21) Application number: 25795554.2
(22) Date of filing: 12.05.2025
(51) Int. Cl.: G11C 5/06, G11C 7/10

(54) **DATA INPUT/OUTPUT CIRCUIT AND MEMORY**

(30) Priority: 09.10.2024 CN 202411400832
(71) Applicant: CXMT Corporation, Hefei, Anhui 230601 (CN)
(72) Inventor: CAO, Kanyu, Hefei, Anhui 230601 (CN); YE, Bingxiang, Hefei, Anhui 230601 (CN); ZHANG, Zhiqiang, Hefei, Anhui 230601 (CN)
(74) Representative: Gulde & Partner
(86) International application number: PCT/CN2025/094294
(87) International publication number: WO 2026/076942

(57) **Abstract**

Embodiments of this application relate to the field of memories, and provide a data input/output circuit and a memory. The data input/output circuit includes a parallel-to-serial conversion circuit, configured to receive N pieces of data, and serially output the N pieces of data in a first time period; a read enable signal generation circuit, configured to generate a read enable signal, the read enable signal being at an active level in the first time period; a resistance control circuit, electrically connected to the read enable signal generation circuit, and configured to receive a termination resistance control code, an output drive resistance control code, and the read enable signal, and choose, based on the read enable signal, to output the termination resistance control code or output the output drive resistance control code; and an output drive circuit, electrically connected to the parallel-to-serial conversion circuit and the resistance control circuit, and configured to receive the N pieces of data and a signal output by the resistance control circuit, configure an output drive resistance value based on the signal output by the resistance control circuit and output the N pieces of data, or configure a termination resistance value, where N is a positive integer greater than 1.

## Description

This application claims priority to Chinese Patent Application No. 202411400832.2, filed with the China National Intellectual Property Administration on October 9, 2024 and entitled "DATA INPUT/OUTPUT CIRCUIT AND MEMORY", which is incorporated herein by reference in its entirety.

### TECHNICAL FIELD

Embodiments of this application relate to the field of memories, and in particular, to a data input/output circuit and a memory that includes the input/output circuit.

### BACKGROUND

Currently, a memory plays a very important role in various electronic devices. When a data read/write operation is performed in a memory (e.g., a dynamic random access memory, DRAM), data needs to be read and written through a data input/output terminal (DQ). To ensure stable transmission of the data on the DQ, an ODT resistance (On-Die Termination resistance) and an ODI resistance (output drive resistance) need to be configured. In high-speed data transmission, signal reflection and signal attenuation cause signal quality degradation and increase a bit error rate. A value of the ODT resistance may match a characteristic impedance of a data bus, reduce/absorb reflection of a signal, and ensure stable transmission of the data on a DQ pin. During data output, by adjusting a value of the output drive resistance, drive strength of an output signal can be controlled to match a characteristic impedance of an external bus, thereby reducing signal reflection and improving signal integrity and stability.

However, a strict timing requirement exists in a read/write operation of the memory. Therefore, a corresponding timing requirement also exists for configuration of an ODT resistance and an output drive resistance, so that the ODT resistance and the output drive resistance can match timing of a read operation, a write operation and another operation, and data can be correctly read from/written into the memory. How to design a data input/output circuit, so that by controlling the data input/output circuit, the memory can perform impedance matching during different operations is a problem that urgently needs to be resolved.

### SUMMARY

Embodiments of this application provide a data input/output circuit and a memory that includes the input/output circuit, which at least help resolve a problem of how to perform impedance matching during different operations at a DQ terminal.

According to some embodiments of this application, an aspect of the embodiments of this application provides a data input/output circuit, including a parallel-to-serial conversion circuit, a read enable signal generation circuit, a resistance control circuit, and an output drive circuit, where the parallel-to-serial conversion circuit is configured to receive N pieces of data, and serially output the N pieces of data in a first time period; the read enable signal generation circuit is configured to generate a read enable signal, and the read enable signal is at an active level in the first time period; the resistance control circuit is electrically connected to the read enable signal generation circuit, and is configured to receive a termination resistance control code, an output drive resistance control code, and the read enable signal, and choose, based on the read enable signal, to output the termination resistance control code or output the output drive resistance control code; and the output drive circuit is electrically connected to the parallel-to-serial conversion circuit and the resistance control circuit, and is configured to receive the N pieces of data and a signal output by the resistance control circuit, configure an output drive resistance value based on the signal output by the resistance control circuit and output the N pieces of data, or configure a termination resistance value, where N is a positive integer greater than 1.

In some embodiments, the data input/output circuit further includes a pull-up drive circuit and a pull-down drive circuit, and the parallel-to-serial conversion circuit is connected to the pull-up drive circuit and the pull-down drive circuit, and outputs the N pieces of data to the pull-up drive circuit and the pull-down drive circuit.

In some embodiments, the parallel-to-serial conversion circuit includes a first data input port, a second data input port, a third data input port, and a fourth data input port, and the parallel-to-serial conversion circuit receives the N pieces of data through the first to fourth data input ports; and the parallel-to-serial conversion circuit further receives a first clock, a second clock, a third clock, and a fourth clock, samples the N pieces of data based on the first to fourth clocks, and serially outputs the N pieces of data in a first time period;
the first time period includes a second time period, a third time period, and a fourth time period, the second time period is earlier than the third time period, and the third time period is earlier than the fourth time period; and the parallel-to-serial conversion circuit is further configured to fixedly output a first level in the second time period and the fourth time period, and serially output the N pieces of data in the third time period; and
clock frequencies of the first clock, the second clock, the third clock, and the fourth clock are the same, and phase differences sequentially differ by one quarter of a cycle; and N is a positive integer multiple of 4.

In some embodiments, the parallel-to-serial conversion circuit includes a first sampling circuit, a second sampling circuit, and a first NAND gate; a first input terminal of the first sampling circuit receives the first clock, and a second input terminal of the first sampling circuit is connected to the first data input port, and samples, through the first clock, data input by the first data input port; a first input terminal of the second sampling circuit receives the second clock, and a second input terminal of the second sampling circuit receives a second level, and samples the second level through the second clock; and a first input terminal of the first NAND gate is connected to an output terminal of the first sampling circuit, a second input terminal of the first NAND gate is connected to an output terminal of the second sampling circuit, and the first NAND gate outputs a first sampling result;
the parallel-to-serial conversion circuit further includes a third sampling circuit, a fourth sampling circuit, and a second NAND gate; a first input terminal of the third sampling circuit receives the third clock, and a second input terminal of the third sampling circuit is connected to the third data input port, and samples, through the third clock, data input by the third data input port; a first input terminal of the fourth sampling circuit receives the fourth clock, and a second input terminal of the fourth sampling circuit receives the second level, and samples the second level through the fourth clock; and a first input terminal of the second NAND gate is connected to an output terminal of the third sampling circuit, a second input terminal of the second NAND gate is connected to an output terminal of the fourth sampling circuit, and the second NAND gate outputs a third sampling result;
the parallel-to-serial conversion circuit further includes a fifth sampling circuit, a sixth sampling circuit, and a third NAND gate; a first input terminal of the fifth sampling circuit receives the second clock, and a second input terminal of the fifth sampling circuit is connected to the second data input port, and samples, through the second clock, data input by the second data input port; a first input terminal of the sixth sampling circuit receives the third clock, and a second input terminal of the sixth sampling circuit receives the second level, and samples the second level through the third clock; and a first input terminal of the third NAND gate is connected to an output terminal of the fifth sampling circuit, a second input terminal of the third NAND gate is connected to an output terminal of the sixth sampling circuit, and the third NAND gate outputs a second sampling result;
the parallel-to-serial conversion circuit further includes a seventh sampling circuit, an eighth sampling circuit, and a fourth NAND gate; a first input terminal of the seventh sampling circuit receives the fourth clock, and a second input terminal of the seventh sampling circuit is connected to the fourth data input port, and samples, through the fourth clock, data input by the fourth data input port; a first input terminal of the eighth sampling circuit receives the first clock, and a second input terminal of the eighth sampling circuit receives the second level, and samples the second level through the first clock; and a first input terminal of the fourth NAND gate is connected to an output terminal of the seventh sampling circuit, a second input terminal of the fourth NAND gate is connected to an output terminal of the eighth sampling circuit, and the fourth NAND gate outputs a fourth sampling result; and
a first AND logic circuit is connected to the first to fourth NAND gates, receives the first to fourth sampling results, and performs first AND logic processing on the first to fourth sampling results, so as to output the first level in the second time period and the fourth time period, and serially output the N pieces of data in the third time period.

In some embodiments, the resistance control circuit includes a first selection circuit, and the first selection circuit is configured to receive a termination resistance control code, an output drive resistance control code, and the read enable signal; when the read enable signal is at an active level, an output terminal of the first selection circuit outputs the output drive resistance control code or an inverted signal of the output drive resistance control code; and when the read enable signal is at an inactive level, the output terminal of the first selection circuit outputs the termination resistance control code.

In some embodiments, the first selection circuit includes a fifth NAND gate, a sixth NAND gate, and a seventh NAND gate; a first input terminal of the fifth NAND gate receives the read enable signal, and a second input terminal of the fifth NAND gate receives the output drive resistance control code or the inverted signal of the output drive resistance control code; a first input terminal of the sixth NAND gate receives an inverted signal of the read enable signal, and a second input terminal of the sixth NAND gate receives the termination resistance control code; and two input terminals of the seventh NAND gate are respectively connected to an output terminal of the fifth NAND gate and an output terminal of the sixth NAND gate, and an output terminal of the seventh NAND gate is taken as the output terminal of the first selection circuit.

In some embodiments, the resistance control circuit includes a first selection circuit, and the first selection circuit is configured to receive a termination resistance control code, an output drive resistance control code, and the read enable signal; when the read enable signal is at an active level, an output terminal of the first selection circuit outputs the output drive resistance control code or an inverted signal of the output drive resistance control code to the pull-up drive circuit; and when the read enable signal is at an inactive level, the output terminal of the first selection circuit outputs the termination resistance control code or an inverted signal of the termination resistance control code to the pull-up drive circuit; and
the resistance control circuit further includes a second selection circuit, and the second selection circuit is configured to receive an inactive level, an output drive resistance control code, and the read enable signal; when the read enable signal is at an active level, an output terminal of the second selection circuit outputs the output drive resistance control code or an inverted signal of the output drive resistance control code to the pull-down drive circuit; and when the read enable signal is at an inactive level, the output terminal of the second selection circuit outputs the inactive level to the pull-down drive circuit.

In some embodiments, the output drive circuit includes a pre-drive circuit and a main drive circuit, the pre-drive circuit includes a second AND logic circuit, a first input terminal of the second AND logic circuit receives the N pieces of data, and a second input terminal of the second AND logic circuit receives a signal output by the resistance control circuit;
the second AND logic circuit performs NAND logic processing on a signal received at the first input terminal and the signal received at the second input terminal, and then outputs a signal, the main drive circuit includes a PMOS transistor electrically connected between a power supply voltage and an output port, and a control terminal of the PMOS transistor receives the signal output by the second AND logic circuit; or
the second AND logic circuit performs AND logic processing on a signal received at the first input terminal and the signal received at the second input terminal, and then outputs a signal, the main drive circuit includes an NMOS transistor electrically connected between a power supply voltage and an output port, and a control terminal of the NMOS transistor receives the signal output by the second AND logic circuit.

In some embodiments, the pull-up drive circuit is connected to an output terminal of the parallel-to-serial conversion circuit, and receives the N pieces of data in the first time period; and the pull-down drive circuit is connected to the output terminal of the parallel-to-serial conversion circuit, and receives the N pieces of data in the first time period;
the pull-up drive circuit is configured to output a high level among the N pieces of data in the first time period, and configure an output drive resistance value based on the output drive resistance control code; and the pull-down drive circuit is configured to output a low level among the N pieces of data in the first time period, and configure an output drive resistance value based on the output drive resistance control code; and
the pull-up drive circuit is further configured to configure a termination resistance value outside the first time period.

According to some embodiments of this application, another aspect of the embodiments of this application further provides a memory, where the memory includes the input/output circuit according to any one of the foregoing embodiments, the memory further includes a storage array and a data transmission circuit, and the storage array stores data; and when a read operation is performed on the memory, data is read from the storage array, transmitted by the data transmission circuit, and then output from the data input/output circuit.

The technical solution provided in this embodiment of this application has at least the following advantages: The memory may perform impedance matching during a corresponding operation of a read operation and a non-read operation. Because timing of switching a termination resistance RTT state is the same as timing of outputting data during a read operation, the timing of switching a termination resistance RTT state and the timing of controlling data output are multiplexed, and a termination resistance control code or an output drive resistance control code is selected based on a read enable signal, so that an output control codeword signal matches timing of outputting data by a parallel-to-serial conversion circuit. Therefore, power consumption and a circuit area can be reduced, and impact on tADC can be avoided. In addition, the termination resistance control code and the output drive resistance control code are merged and operated in a resistance control circuit, which can ensure normal operation of the circuit and reduce an area of the circuit.

### BRIEF DESCRIPTION OF DRAWINGS

One or more embodiments are exemplified with the figures in the accompanying drawings corresponding to the one or more embodiments. These example descriptions are not intended to limit the embodiments, and unless specifically stated, no scale limitations are constituted by the figures in the accompanying drawings.
FIG. 1 is a schematic structural diagram of a data input/output circuit according to an embodiment of the present disclosure;
FIG. 2 is a schematic structural diagram of another data input/output circuit according to an embodiment of the present disclosure;
FIG. 3 is a schematic structural diagram of a parallel-to-serial conversion circuit according to an embodiment of the present disclosure;
FIG. 4 is a timing diagram of a parallel-to-serial conversion circuit according to an embodiment of the present disclosure;
FIG. 5 is a schematic structural diagram of a read enable signal generation circuit according to an embodiment of the present disclosure;
FIG. 6 is a timing diagram of a read enable signal generation circuit according to an embodiment of the present disclosure;
FIG. 7 is a schematic structural diagram of a first selection circuit according to an embodiment of the present disclosure;
FIG. 8 is a timing diagram of a first selection circuit according to an embodiment of the present disclosure;
FIG. 9 is a schematic diagram of a circuit structure of a second selection circuit according to an embodiment of the present disclosure;
FIG. 10 is a schematic structural diagram of a pull-up pre-drive circuit according to an embodiment of the present disclosure;
FIG. 11 is a schematic structural diagram of a first sub-pull-up main drive circuit according to an embodiment of the present disclosure; and
FIG. 12 is a schematic structural diagram of a memory according to an embodiment of the present disclosure.

### DESCRIPTION OF EMBODIMENTS

The following describes example embodiments of the present disclosure in detail with reference to the accompanying drawings, so that those skilled in the art can readily practice the present disclosure. As will be recognized by a person skilled in the art, the described embodiments may be modified in various manners, and none of these modifications departs from the spirit or scope of the present disclosure. For example, the example embodiments provided herein are considered to be implemented in combination with one another in whole or in part. Specifically, an element described in a specific example embodiment may be understood as a description related to another example embodiment, even if not described in another example embodiment, unless opposite or contradictory descriptions are provided therein.

Throughout this specification, when any part is described as being "connected" to another part, the connection includes a case where any part is "indirectly connected" to another part due to other parts being located therebetween, and a case where any part is "directly connected" to another part. For example, it should be understood that when an element is described as being "connected to", "coupled to", or "on" another element, the element may be directly connected to, coupled to, or on the another element, or an intermediate element may exist between the element and the another element. Conversely, when an element is described as being "directly connected" or "directly coupled" to another element, or described as "making contact with" or "in contact with" another element, no intermediate element exists at the point of contact.

In addition, the concept of "electrical connection" includes physical connection and physical disconnection. It may be understood that when a term such as "first" and "second" is used to refer to an element, the element is not limited thereto. The terms may be only used to separate the element from another element, and may not limit the order or importance of the element. In some cases, the first element may be referred to as a second element without departing from the scope of the claims set forth herein. Similarly, the second element may also be referred to as the first element.

Embodiments of this application are described in detail below with reference to the accompanying drawings. However, it may be understood by a person of ordinary skill in the art that in the embodiments of this application, many technical details are provided to enable readers to better understand this application. However, the technical solutions claimed in this application may be implemented even without these technical details and various changes and modifications made based on the following embodiments.

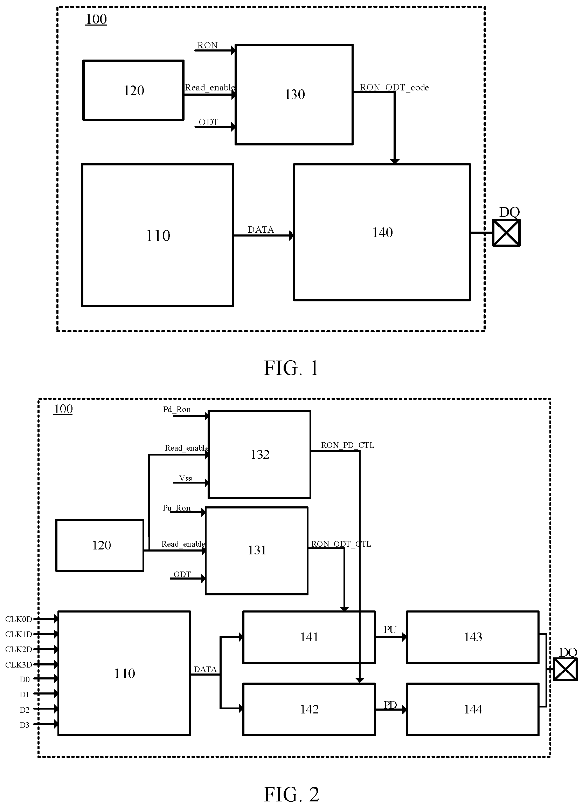

FIG. 1 is a schematic structural diagram of a data input/output circuit according to an embodiment of the present disclosure. As shown in FIG. 1, a data input/output circuit 100 includes a parallel-to-serial conversion circuit 110, a read enable signal generation circuit 120, a resistance control circuit 130, and an output drive circuit 140. The parallel-to-serial conversion circuit 110 is configured to receive inverted signals D₀B, D₁B, D₂B ..., D_{N-2}B, and D_{N-1}B of N pieces of data D₀, D₁, D₂ ..., D_{N-2}, and D_{N-1}, and serially output the N pieces of data D₀-D_{N-1} as an output signal DATA of the parallel-to-serial conversion circuit 110 in a first time period. N is a positive integer greater than 1, e.g., 4, 8, 16, or 32. In some other embodiments, N may alternatively be another value.

The read enable signal generation circuit 120 is configured to generate a read enable signal Read_enable, where the read enable signal Read_enable is at an active level in the first time period. In the embodiments of the present disclosure, a high level being an active level is taken as an example. It should be understood that a low level may also be taken as an active level. Conversion between the high and low levels can be implemented through simple inversion processing. In a signal transmission process, a signal often passes through a circuit driver such as an inverter. Therefore, for a same signal, the signal can be obtained again by performing simple inversion processing on an inverted signal of the signal. Therefore, it is common to use a high level or a low level as an active level. Unless otherwise specified, in the embodiments of the present disclosure, a signal itself and an inverted signal of the signal are considered as embodiments involving simple variations.

The resistance control circuit 130 is electrically connected to the read enable signal generation circuit 120, and is configured to receive a termination resistance control code ODT, an output drive resistance control code RON, and the read enable signal Read_enable, and select, based on the read enable signal Read _enable, the termination resistance control code ODT or the output drive resistance control code RON as an output signal RON_ODT_code of the resistance control circuit 130.

The output drive circuit 140 is electrically connected to the parallel-to-serial conversion circuit 110 and the resistance control circuit 130, and is configured to receive the N pieces of data (DATA) and the output signal RON_ODT_code of the resistance control circuit 130, and configure an output drive resistance value based on the output signal RON_ODT_code of the resistance control circuit 130 and output the N pieces of data, or configure a termination resistance value.

Specifically, when a memory performs a read operation and outputs data through the input/output circuit and a DQ terminal, the parallel-to-serial conversion circuit 110 outputs the data DATA in the first time period. In this case, the read enable signal Read_enable is at an active level. The resistance control circuit 130 selects the output resistance control code RON as the output signal RON_ODT_code of the resistance control circuit 130 based on the active level of the read enable signal Read_enable. The output drive circuit 140 serially outputs, based on the output drive resistance control code RON, the data DATA received from the parallel-to-serial conversion circuit 110, and configures a corresponding output drive resistance value.

When the memory is in another phase of the read operation, or is in a write operation or another operation, the input/output circuit and the DQ terminal do not output data. In this case, the parallel-to-serial conversion circuit 110 does not output the data DATA, the read enable signal Read_enable is at an inactive level, and the resistance control circuit 130 selects, based on the inactive level of the read enable signal Read _enable, the termination resistance control code ODT as the output signal RON_ODT_code of the resistance control circuit 130. The output drive circuit 140 configures a corresponding termination resistance value based on the termination resistance control code ODT.

That is, the embodiments of the present disclosure provide a data input/output circuit, including a parallel-to-serial conversion circuit, a read enable signal generation circuit, a resistance control circuit, and an output drive circuit. A read enable signal generated by the read enable signal generation circuit matches timing of outputting data by the parallel-to-serial conversion circuit (that is, the read enable signal is at an active level in a first time period in which the parallel-to-serial conversion circuit serially outputs data), and the resistance control circuit receives a termination resistance control code and an output drive resistance control code, and chooses to output the termination resistance control code or the output drive resistance control code based on timing of outputting data by the parallel-to-serial conversion circuit through the read enable signal, so as to control the output drive circuit to configure an output drive resistance value and output data corresponding to a read operation, or configure a termination resistance value corresponding to a non-read operation Therefore, the memory can perform impedance matching during a corresponding operation of a read operation and a non-read operation. Because timing of switching a termination resistance RTT state is the same as timing of outputting data during a read operation, the timing of switching a termination resistance RTT state and the timing of controlling data output are multiplexed. Therefore, power consumption and a circuit area can be reduced, and impact on tADC can be avoided. In addition, the termination resistance control code and the output drive resistance control code are merged and operated in a resistance control circuit, which can ensure normal operation of the circuit and reduce an area of the circuit.

FIG. 2 is a schematic structural diagram of another data input/output circuit according to an embodiment of the present disclosure. In some cases, the embodiment may be an extended implementation of the embodiment shown in FIG. 1, and includes all content of the embodiment shown in FIG. 1. As shown in FIG. 1 and FIG. 2, the data input/output circuit 100 includes the parallel-to-serial conversion circuit 110, the read enable signal generation circuit 120, the resistance control circuit 130, and the output drive circuit 140. Specifically, the output drive circuit 140 includes pull-up drive circuits 141 and 143, and pull-down drive circuits 142 and 144. The parallel-to-serial conversion circuit 110 is connected to the pull-up drive circuit 141 and the pull-down drive circuit 142, and outputs N pieces of data DATA to the pull-up drive circuit 141 and the pull-down drive circuit 142.

The resistance control circuit 130 includes a pull-up resistance control circuit 131 and a pull-down resistance control circuit 132. The pull-up resistance control circuit 131 receives a termination resistance control code ODT, an output drive resistance control code RON, and a read enable signal Read_enable, and configures, based on the read enable signal Read_enable, an output drive resistance value or a termination resistance value for the pull-up drive circuit 141. The pull-down resistance control circuit 132 receives an output drive resistance control code RON and a read enable signal Read_enable, and configures an output drive resistance value for the pull-down drive circuit 142 based on the read enable signal Read _enable, or sets the pull-down drive circuit 142 to a floating state (or a high-impedance state). When the read enable signal Read_enable is at an active level, the pull-down resistance control circuit 132 selects an output drive resistance control code RON as an output signal RON_PD_CTL of the pull-down resistance control circuit 132. When the read enable signal Read_enable is at an inactive level, the pull-down resistance control circuit 132 outputs an inactive level, and the corresponding pull-down drive circuit 142 is turned off, so that the pull-down drive circuit 142 outputs an inactive level (or is in a high-impedance state). In some other embodiments, the pull-down resistance control circuit 132 may further receive a low level Vss, so as to be conducive to performing circuit design corresponding to the termination resistance control code ODT received by the pull-up resistance control circuit 131.

In some embodiments, the output drive resistance control code RON includes a pull-up output drive resistance control code Pu_Ron and a pull-down output drive resistance control code Pd_Ron. The pull-up resistance control circuit 131 outputs the pull-up output drive resistance control code Pu_Ron or the termination resistance control code ODT to the pull-up drive circuit 141. The pull-down resistance control circuit 132 outputs the pull-down output drive resistance control code Pd_Ron or outputs an inactive level to the pull-down drive circuit 142.

In this embodiment, because the pull-up drive circuit 141 and the pull-down drive circuit 142 receive a control signal that includes timing and that undergoes selection processing, the pull-up drive circuit 141 and the pull-down drive circuit 142 may be connected to a same parallel-to-serial conversion circuit to receive same data DATA.

Before and after the memory reads the data, it is necessary to ensure that a level of the DQ terminal is in a floating state. Because circuit structures of the pull-up drive circuit and the pull-down drive circuit are different, in the prior art, when parallel-to-serial conversion is performed on data, two parallel-to-serial conversion circuits need to be separately used to output the data to the pull-up drive circuit and the pull-down drive circuit, so that before and after the N pieces of data are read, the pull-up drive circuit receives a default signal output by one parallel-to-serial conversion circuit, thereby enabling the level of the DQ terminal to be in a floating state (that is, in a high-impedance state), and the pull-down drive circuit receives a default signal output by the other parallel-to-serial conversion circuit, thereby enabling the level of the DQ terminal to be in a floating state (that is, in a high-impedance state). For example, when the pull-up drive circuit includes a PMOS transistor, and the pull-down drive circuit includes an NMOS transistor, the pull-up drive circuit outputs a high-impedance state when receiving a high-level signal, and the pull-down drive circuit outputs a high-impedance state when receiving a low-level signal. In this case, requirements of the pull-up drive circuit and the pull-down drive circuit for a control signal are different. That is, two parallel-to-serial conversion circuits are needed. When the memory does not read data, the pull-up drive circuit receives an inactive level, and the pull-down drive circuit receives an inactive level, so that output of the DQ terminal is maintained in a high-impedance state.

According to the solution in the embodiments of the present disclosure, because timing of switching a termination resistance RTT state is the same as timing of outputting data during a read operation, the timing of switching a termination resistance RTT state (termination resistance control timing) is used to control the pull-up drive circuit 141, so that during a non-read operation, the pull-up resistance control circuit can directly configure a termination resistance value of the pull-up drive circuit (while maintaining output of the DQ terminal in a high-impedance state). Therefore, the pull-up drive circuit and the pull-down drive circuit may be connected to a same parallel-to-serial conversion circuit (that is, the parallel-to-serial conversion circuit only needs to ensure that output of the pull-down drive circuit is maintained in a high-impedance state), thereby implementing multiplexing of the parallel-to-serial conversion circuit, and further reducing a circuit area on the premise of ensuring normal operation of the circuit.

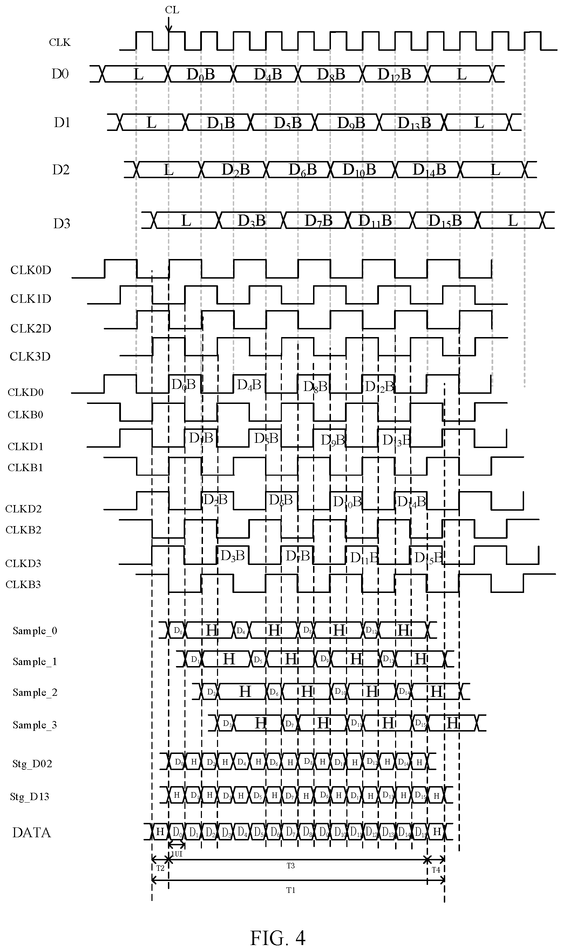

In some embodiments, referring to FIG. 2, the parallel-to-serial conversion circuit 110 may include a first data input port D0, a second data input port D1, a third data input port D2, and a fourth data input port D3, and the parallel-to-serial conversion circuit 110 receives inverted signals D₀B-D_{N-1}B of N pieces of data D₀-D_{N-1} through the first to fourth data input ports D0-D3. The parallel-to-serial conversion circuit further receives a first clock CLKOD, a second clock CLK1D, a third clock CLK2D, and a fourth clock CLK3D, samples the inverted signal D₀B-D_{N-1}B of the N pieces of data D₀-D_{N-1} based on the first to fourth clocks CLK0D-CLK3D, and serially outputs the N pieces of data in a first time period T1. Referring to FIG. 4, clock frequencies of the first clock CLK0D, the second clock CLK1D, the third clock CLK2D, and the fourth clock CLK3D are the same, and phase differences sequentially differ by one quarter of a cycle. In some embodiments, N may be a positive integer multiple of 4, e.g., 4, 8, 16, and 32, and the first to fourth data input ports D0 to D3 sequentially receive the inverted signals of the N pieces of data D₀-D_{N-1}, and the inverted signals are alternately sampled by the first to fourth clocks CLK0D-CLK3D. In some other embodiments, N may not be a positive integer multiple of 4, only normal sampling is needed, and then redundant data is masked. For example, N may be 15, and a last bit of sampled data is considered invalid data.

Referring to FIG. 4 which is merely taken as an example, the first time period T1 includes a second time period T2, a third time period T3, and a fourth time period T4, the second time period T2 is earlier than the third time period T3, and the third time period T3 is earlier than the fourth time period T4. The parallel-to-serial conversion circuit is further configured to fixedly output a first level in the second time period and the fourth time period, and serially output N pieces of data in the third time period. In some embodiments, the first level may be a high level. Correspondingly, the high level enters a pull-up output circuit including a PMOS transistor and a pull-down output circuit including an NMOS transistor at the DQ terminal after being inverted, so that the pull-up output circuit outputs a high level at the DQ terminal in the second time period T2 and the fourth time period T4, and the pull-down output circuit outputs a high-impedance state in the second time period T2 and the fourth time period T4. In some other embodiments, the first level may alternatively be a low level. Correspondingly, the low level enters the pull-up output circuit including the PMOS transistor and the pull-down output circuit including the NMOS transistor at the DQ terminal without being inverted, so that the pull-up output circuit outputs a high level at the DQ terminal in the second time period T2 and the fourth time period T4, and the pull-down output circuit outputs a high-impedance state at the DQ terminal in the second time period T2 and the fourth time period T4. In some other embodiments, the pull-up output circuit may alternatively include an NMOS transistor, and/or the pull-down output circuit may alternatively include a PMOS transistor. In this case, a high level may enter the pull-up output circuit and/or the pull-down output circuit without being inverted, so as to output a high-impedance state at the DQ terminal, and a low level may enter the pull-up output circuit and/or the pull-down output circuit after being inverted, so as to output a high-impedance state at the DQ terminal.

In some other embodiments, the first time period T1 further includes another time period in addition to the second time period T2, the third time period T3, and the fourth time period T4. That is, the second time period T2 and the third time period T3 may be non-consecutive, and the third time period T3 and the fourth time period T4 may be non-consecutive.

In some embodiments, the time length of the second time period is a unit time interval (1 UI, 1 Unit Interval), the time length of the fourth time period is a unit time interval (1 UI), and the width of each of the N pieces of data D₀-D_{N-1} is also 1 UI, so as to facilitate measurement of tADC.

Therefore, through the second time period and the fourth time period, and setting fixed level output in the second time period and the fourth time period, preset information for tADC measurement may be manually set before and after the N pieces of data are output, so as to measure whether the tADC meets a requirement.

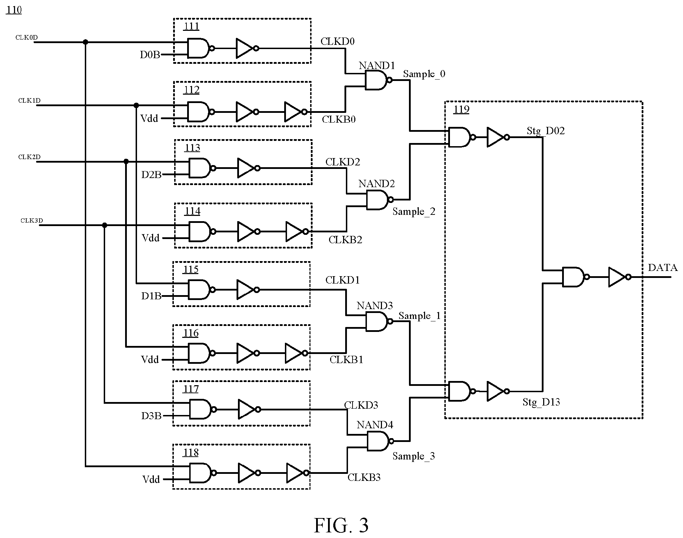

FIG. 3 is a schematic structural diagram of a parallel-to-serial conversion circuit according to an embodiment of the present disclosure. FIG. 4 illustrates a timing diagram of the parallel-to-serial conversion circuit. Referring to FIG. 3, the parallel-to-serial conversion circuit 110 includes a first sampling circuit 111, a second sampling circuit 112, and a first NAND gate NAND1. A first input terminal of the first sampling circuit 111 receives a first clock CLK0D, and a second input terminal of the first sampling circuit is connected to a first data input port D0, receives data input into the first data input port D0, and samples the data input into the first data input port D0 through the first clock CLK0D.

In FIG. 4, N=16 is taken as an example. Inverted signals D₀B, D₄B, D₈B, and D₁₂B of data D₀, D₄, D₈, and D₁₂ are sequentially transmitted into the first data input port D0, with a default low level L when no data is being transmitted, and the first clock CLK0D sequentially samples these signals to obtain a sampling result CLKD0. In FIG. 3, the first sampling circuit 111 is illustrated as an AND gate (NAND gate + NOT gate). In some other embodiments, all sampling circuits including the first sampling circuit may alternatively use a sampling circuit such as an OR gate (NOR gate and NOT gate) and a flip-flop (such as a D flip-flop).

A first input terminal of the second sampling circuit 112 receives a second clock CLK1D, and a second input terminal of the second sampling circuit 112 receives a second level Vdd, samples the second level Vdd through the second clock CLK1D, and inverts the sampled data. A first input terminal of the first NAND gate NAND1 is connected to an output terminal of the first sampling circuit 111, and receives a sampling result CLKD0 output by the first sampling circuit. A second input terminal of the first NAND gate NAND1 is connected to an output terminal of the second sampling circuit 112, and receives a sampling result CLKB0 output by the second sampling circuit. After performing a NAND operation on CLKD0 and CLKB0, the first NAND gate outputs a first sampling result Sample_0.

When the second sampling circuit is an AND gate, the second level Vdd is correspondingly set to a high level H. In some other embodiments, the second level may be a low level. Correspondingly, the second sampling circuit uses an OR gate, and the second sampling circuit does not perform inversion processing on the sampling result.

The parallel-to-serial conversion circuit 110 further includes a third sampling circuit 113, a fourth sampling circuit 114, and a second NAND gate NAND2. A first input terminal of the third sampling circuit 113 receives a third clock CLK2D, and a second input terminal of the third sampling circuit 113 is connected to a third data input port D2, receives data input by the third data input port D2, and samples the data (e.g., D₂, D₆, D₁₀, and D₁₄ in FIG. 4) input by the third data input port D2 through the third clock CLK2D to obtain a sampling result CLKD2. A first input terminal of the fourth sampling circuit 114 receives a fourth clock CLK3D, and a second input terminal of the fourth sampling circuit 114 receives a second level Vdd, samples the second level Vdd through the fourth clock CLK3D, and then performs inversion processing to obtain a sampling result CLKB2. A first input terminal of the second NAND gate NAND2 is connected to an output terminal of the third sampling circuit 113, and receives a sampling result CLKD2 output by the output terminal of the third sampling circuit 113. A second input terminal of the second NAND gate NAND2 is connected to an output terminal of the fourth sampling circuit, and receives a sampling result CLKB2 output by the output terminal of the fourth sampling circuit. The second NAND gate NAND2 performs NAND logic processing on CLKD2 and CLKB2, and outputs a third sampling result Sample_2.

The parallel-to-serial conversion circuit further includes a fifth sampling circuit 115, a sixth sampling circuit 116, and a third NAND gate NAND3. A first input terminal of the fifth sampling circuit 115 receives the second clock CLK1D, and a second input terminal of the fifth sampling circuit 115 is connected to a second data input port D1, and receives data (e.g., D₁, D₅, D₉, and D₁₃ in FIG. 4) input by the second data input port D1. The second clock CLK1D samples the data input by the second data input port D1 to obtain a sampling result CLKD1. A first input terminal of the sixth sampling circuit 116 receives a third clock CLK2D, and a second input terminal of the sixth sampling circuit 116 receives a second level Vdd, samples the second level Vdd through the third clock CLK2D, and then performs inversion processing to obtain a sampling result CLKB1. A first input terminal of the third NAND gate NAND3 is connected to an output terminal of the fifth sampling circuit 115, and receives a sampling result CLKD1 output by the output terminal of the fifth sampling circuit 115. A second input terminal of the third NAND gate NAND3 is connected to an output terminal of the sixth sampling circuit 116, and receives a sampling result CLKB1 output by the output terminal of the sixth sampling circuit 116. The third NAND gate NAND3 performs NAND logic processing on CLKD1 and CLKB1, and outputs a second sampling result Sample_1.

The parallel-to-serial conversion circuit 110 further includes a seventh sampling circuit 117, an eighth sampling circuit 118, and a fourth NAND gate NAND4. A first input terminal of the seventh sampling circuit 117 receives the fourth clock CLK3D, and a second input terminal of the seventh sampling circuit 117 is connected to a fourth data input port D3, and receives data (e.g., D₃, D₇, D₁₁, and D₁₅ in FIG. 4) input by the fourth data input port D3. The fourth clock CLK3D samples the data input by the fourth data input port D3 to obtain a sampling result CLKD3. A first input terminal of the eighth sampling circuit 118 receives the first clock CLK0D, and a second input terminal of the eighth sampling circuit 118 receives a second level Vdd, and samples the second level Vdd through the first clock CLK0D to obtain a sampling result CLKB3. A first input terminal of the fourth NAND gate NAND4 is connected to an output terminal of the seventh sampling circuit 117, and receives a sampling result CLKD3 output by the output terminal of the seventh sampling circuit 117. A second input terminal of the fourth NAND gate NAND4 is connected to an output terminal of the eighth sampling circuit 118, and receives a sampling result CLKB3 output by the output terminal of the eighth sampling circuit 118. The fourth NAND gate NAND4 performs NAND logic processing on CLKD3 and CLKB3, and outputs a fourth sampling result Sample _3.

The foregoing takes an AND logic circuit as an example of a sampling circuit. However, it should be understood that an OR logic circuit or a timing circuit (e.g., a flip-flop circuit, specifically, a D flip-flop circuit) may also implement the foregoing sampling logic, so as to be taken as another embodiment of a sampling logic circuit.

The parallel-to-serial conversion circuit 110 further includes a first AND logic circuit 119. The first AND logic circuit 119 is connected to output terminals of the first to fourth NAND gates NAND1-NAND4, and receives the first to fourth sampling results Sample_0-Sample_3 output by the first to fourth NAND gates NAND1-NAND4, and performs first AND logic processing on the first to fourth sampling results, so as to output a first level in a second time period and a fourth time period, and serially output N pieces of data in a third time period. In the embodiments of FIG. 3 and FIG. 4, the first level is a high level H. FIG. 3 illustrates an example in which AND logic is implemented through a combination of multiple two-input NAND gates. In some other embodiments, the AND logic may alternatively be directly implemented by, e.g., a four-input NAND gate.

Referring to FIG. 4, CLK is an external clock cycle, and a CL time point is a time point at which a memory starts to output data. The first to fourth data input ports D0-D3 start to sequentially receive N pieces of data from the CL time point. In FIG. 4, N=16 is taken as an example. From the CL time point, the first data input port D0 starts to receive inverted signals D₀B, D₄B, D₈B, and D₁₂B of data D₀, D₄, D₈, and D₁₂. In addition, when not transmitting data, the data signal defaults to a low level (L). A data width of each piece of data is 2T, where T is an external clock cycle, and each half of the external clock cycle is a unit time interval 1 UI. Among the N pieces of data, every two adjacent pieces of data have an interval of 1 UI. Therefore, the second data input port D1 starts to sequentially receive inverted signals D₁B, D₅B, D₉B, and D₁₃B of data D₁, D₅, D₉, and D₁₃ from CL+1 UI, the third data input port D2 starts to sequentially receive inverted signals D₂B, D₆B, D₁₀B, and D₁₄B of data D₂, D₆, D₁₀, and D₁₄ from CL+2 UI, and the fourth data input port D3 starts to sequentially receive inverted signals D₃B, D₇B, D₁₁B, and D₁₅B of data D₃, D₇, D₁₁, and D₁₅ from CL+3 UI. A data width of each piece of data is 2T.

Correspondingly, clock cycles of the first to fourth clocks CLK0D-CLK3D are also 2T, and timing differences are 1 UI in sequence. After sampling, a data width of each of the sampling results CLKD0-CLKB3 is 1T. Then, the width of the sampling result is aligned through a clock which has an interval of 1 UI from a sampling clock to obtain sampling results Sample_0-Sample_3 whose data widths are 1 UI.

That is, the N pieces of data are sequentially sampled through a four-phase clock (the first to fourth clocks CLK0D-CLK3D), and then the width of the sampling result is aligned with a clock that has an interval of 1 UI from the sampling clock, to obtain the first to fourth sampling results Sample_0-Sample_3. In these sampling results, the width of each piece of data is 1 UI. In addition, the first to fourth sampling results Sample_0-Sample_3 carry phase information of the clocks. After data is merged through the first AND logic processing, parallel-to-serial conversion processing of the data may be completed, to obtain N pieces of data that are sequentially serially output at a data width of 1 UI. In addition, when a clock and data are not transmitted, the circuit uses a high-level output as a default state, so that a subsequent output drive circuit can output data in a high-impedance state by default when no data is transmitted.

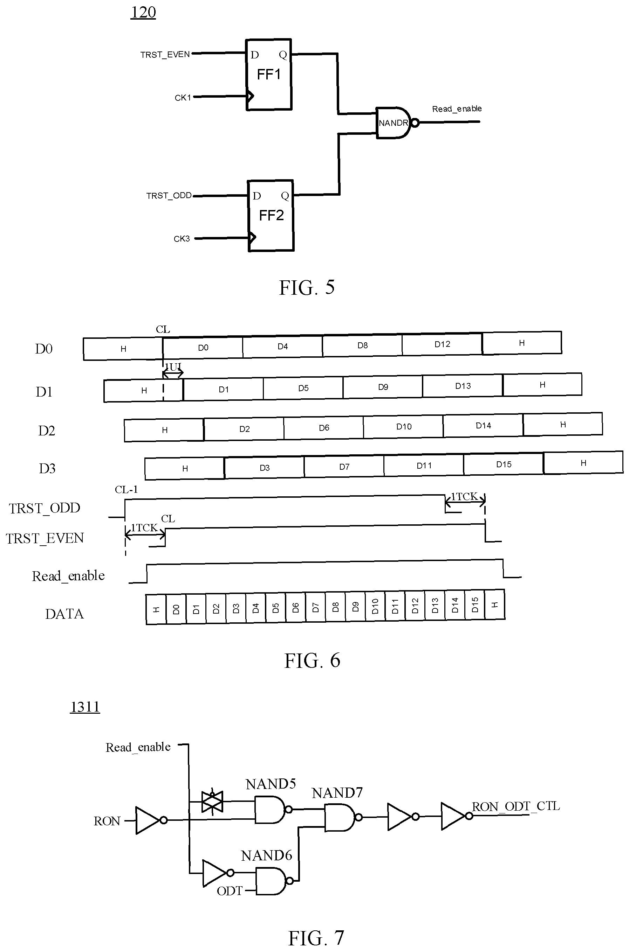

FIG. 5 shows a schematic structural diagram of a read enable signal generation circuit. FIG. 6 illustrates a timing diagram of a read enable signal generation circuit. The read enable signal generation circuit 120 includes an even reset signal sampling circuit FF1, an odd reset signal sampling circuit FF2, and a read enable signal NAND gate NANDR.

The even reset signal sampling circuit takes a D flip-flop (DFF) as an example. A data input terminal of the even reset signal sampling circuit FF1 receives an even reset signal TRST_EVEN that carries ODT timing information, and a clock input terminal receives an even sampling clock signal CK1 corresponding to the even reset signal TRST_EVEN, and samples the even reset signal TRST_EVEN through the even sampling clock signal CK1, so as to match data output timing of the parallel-to-serial conversion circuit to obtain an even sampling result.

The odd reset signal sampling circuit also takes a D flip-flop (DFF) as an example. A data input terminal of the odd reset signal sampling circuit FF2 receives an odd reset signal TRST_ODD that carries ODT timing information, and a clock input terminal receives an odd sampling clock signal CK3, and samples the odd reset signal TRST_ODD through the odd sampling clock signal CK3, so as to match data output timing of the parallel-to-serial conversion circuit to obtain an odd sampling result, where CK1 and CK3 are differential clock signals.

The read enable signal NAND gate NANDR receives the even sampling result and the odd sampling result, and performs AND logic processing on the even sampling result and the odd sampling result to merge odd and even paths, so as to obtain a read enable signal that matches timing of the parallel-to-serial conversion circuit. The read enable signal starts to remain at an active level (shown as a high level in FIG. 6) 1 UI before the data output, ends the active level 1 UI after the data output ends, and jumps to an inactive level.

The odd reset signal and the even reset signal are processing signals of odd and even paths during internal processing. When data is output, the odd and even paths need to be merged. In FIG. 6, that the even reset signal TRST_EVEN first reads data is taken as an example. First, a total of four paths of data sequentially enter the parallel-to-serial conversion circuit from first to fourth data ports D0-D3, and a phase difference between two adjacent paths of data is 1 UI. If the first data entering from D0 is a first bit of data read, and a burst length (BL, Burst Length) is 16, the even reset signal TRST_EVEN starts to be at an active level from a CL time point, the odd reset signal TRST_ODD starts to be at an active level from a CL-1 (T) time point, and pulse widths of the odd reset signal TRST_ODD and the even reset signal TRST_EVEN are both 8T (eight external clock cycles). The sampling clock CK1 has a same source and a same frequency as the first clock, and is 1 UI earlier than the first clock CK0D. CK1 or CK3 starts to sample data at CL-0.5 (T). In an embodiment in which the even reset signal TRST_EVEN first reads data, CK1 starts to sample the data at CL-0.5 (T); and if the odd reset signal TRST_ODD first reads data, CK3 starts to sample the data at CL-0.5 (T). After the NAND gate merges the data, a pulse signal that has a width of 9T and that is at an active level from CL-0.5 to CL+8.5 (T) is generated.

In another embodiment, the read enable signal generation circuit may alternatively be generated through another circuit, as long as it is ensured that a pulse signal which is at an active level from CL-0.5 to CL+8.5 (T) is generated, so as to ensure timing matching between a data signal and a control signal entering the drive circuit.

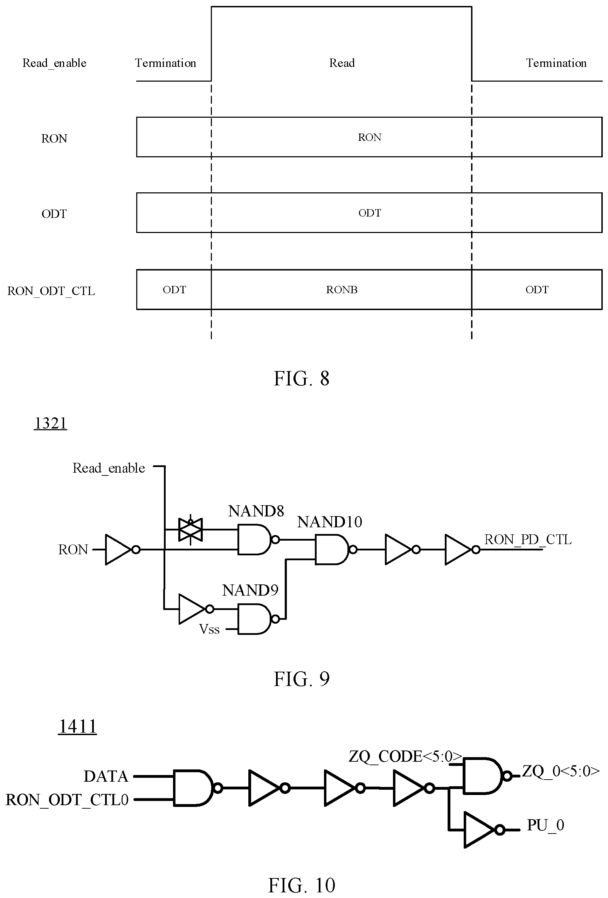

In some embodiments, as shown in FIG. 2, the resistance control circuit 130 includes a first selection circuit 1311. FIG. 7 is a schematic structural diagram of a first selection circuit according to an embodiment of the present disclosure. FIG. 8 illustrates a timing diagram of a first selection circuit. As shown in FIG. 7, the first selection circuit 1311 is configured to receive a termination resistance control code ODT, an output drive resistance control code RON, and a read enable signal Read _enable. When the read enable signal Read_enable is at an active level, an output terminal of the first selection circuit 1311 outputs the drive resistance control code RON as an output signal RON_ODT_CTL of the first selection circuit 1311. When the read enable signal Read_enable is at an inactive level, the output terminal of the first selection circuit 1311 outputs the termination resistance control code ODT as the output signal RON_ODT_CTL of the first selection circuit 1311.

It should be understood that, to improve signal quality, a drive device such as an inverter is disposed everywhere in a digital circuit, so as to improve a drive capability. Because a signal and an inverted signal of the signal can be easily converted through only one inverter, and due to an inverting relationship between drive signals of a PMOS transistor and an NMOS transistor, in the embodiments of the present disclosure, unless otherwise specified, multiple input signals or output signals may be replaced with inverted signal thereof. For example, in FIG. 7, the signal RON_ODT_CTL passes through two stages of inverters when being output. However, based on a requirement of the drive capability, one stage of inverter may also be disposed on a subsequent path. Therefore, when the signal RON_ODT_CTL is output, only one stage of inverter may alternatively be disposed, so that an output signal is an inverted signal of the signal RON_ODT_CTL.

Referring to FIG. 8, FIG. 8 uses an example in which a high level is an active level. When the read enable signal Read_enable is at an inactive level (that is, before data starts to be read), the output signal RON_ODT_CTL (also taken as an output signal of the resistance control circuit) of the first selection circuit 1311 is a termination resistance control code ODT. When the read enable signal Read_enable is at an active level (that is, when data is read), the output signal RON_ODT_CTL (also taken as the output signal of the resistance control circuit) of the first selection circuit 1311 is an inverted signal of an output drive resistance control code RON. When the read enable signal Read_enable is at an inactive level (that is, after data is read), the output signal RON_ODT_CTL (also taken as the output signal of the resistance control circuit) of the first selection circuit 1311 is a termination resistance control code ODT. Therefore, the resistance control circuit automatically outputs different control codes in a read phase (Read) and a non-read phase (Termination), so that different impedances that need to be set in different operation phases (for example, the read and the non-read phases) of the memory can be matched.

The timing in FIG. 8 may be implemented through the circuit in FIG. 7. As shown in FIG. 7, the first selection circuit 1311 includes a fifth NAND gate NAND5, a sixth NAND gate NAND6, and a seventh NAND gate NAND7. A first input terminal of the fifth NAND gate NAND5 receives a read enable signal Read _enable, and a second input terminal of the fifth NAND gate NAND5 receives an output drive resistance control code RON or an inverted signal RONB of the output drive resistance control code RON. A first input terminal of the sixth NAND gate NAND6 receives an inverted signal of the read enable signal Read_enable, and a second input terminal of the sixth NAND gate NAND6 receives a termination resistance control code ODT. Two input terminals of the seventh NAND gate NAND7 are respectively connected to an output terminal of the fifth NAND gate NAND5 and an output terminal of the sixth NAND gate NAND6, and an output terminal of the seventh NAND gate NAND7 is taken as the output terminal of the first selection circuit 1311.

In some embodiments, to match a gate-level delay caused by an inverter in front of the first input terminal of the sixth NAND gate NAND6, the read enable signal Read_enable is connected to the input terminal of the fifth NAND gate NAND5 after passing through a one-stage transmission gate or another gate-level delay for timing matching.

In some embodiments, the first selection circuit may alternatively be implemented through a 2-to-1 multiplexer (Multiplexer). The read enable signal Read_enable is taken as an input signal of a selection terminal, and two input terminals receive the termination resistance control code ODT and the output drive resistance control code RON, so that the output drive resistance control code RON is output when the read enable signal Read_enable is at an active level, and the termination resistance control code ODT is output when the read enable signal Read_enable is at an inactive level. In some other embodiments, the first selection circuit may alternatively be implemented by a NOR gate. The fifth to seventh NAND gates are replaced with NOR gates, and inversion processing of a corresponding input signal or output signal is performed, so that a requirement of selecting an output signal by the read enable signal Read_enable is implemented. A selection circuit implemented through a NAND gate or a NOR gate may match timing, and avoid an MOS transistor superposition effect in a high-speed circuit.

The termination resistance control code ODT and the output drive resistance control code RON may be codewords sent by a memory controller to the memory, and sent by the memory to the data input/output circuit through a register. The termination resistance control code ODT may be a multi-bit control codeword, e.g., a 3-bit control codeword. The output drive resistance control code RON may be a multi-bit control codeword, e.g., a 2-bit control codeword. Correspondingly, the resistance control circuit may have multiple first selection circuits, to correspondingly receive multi-bit control codewords. For example, the resistance control circuit may include four first selection circuits, so as to output codewords of multiple termination resistance control codes ODT and codewords of multiple output drive resistance control codes RON, thereby setting different termination resistance values and output drive resistance values.

In some embodiments, as shown in FIG. 2, the output drive circuit includes pull-up drive circuits 141 and 143 and pull-down drive circuits 142 and 144, and the resistance control circuit 130 includes a pull-up resistance control circuit 131 and a pull-down resistance control circuit 132. The pull-up resistance control circuit 131 may include multiple first selection circuits. Correspondingly, an output drive resistance control code RON received by the first selection circuit 1311 is a pull-up output drive resistance control code Pu_Ron. The pull-down resistance control circuit 132 may also include multiple second selection circuits. Correspondingly, an output drive resistance control code RON received by the second selection circuit is a pull-down output drive resistance control code Pd_Ron. For a memory with pull-up termination, when the memory acts as a termination resistor, only the pull-up drive circuit outputs a termination resistance value, and the pull-down drive circuit is in a high-impedance state.

In this case, the resistance control circuit 130 includes a pull-up resistance control circuit, and the pull-up resistance control circuit includes a first selection circuit 1311. The first selection circuit 1311 is configured to receive a termination resistance control code ODT, an output drive resistance control code RON, and a read enable signal Read _enable. When the read enable signal Read_enable is at an active level, an output terminal of the first selection circuit 1311 outputs an output drive resistance control code RON or an inverted signal of the output drive resistance control code RON to the pull-up drive circuit. When the read enable signal Read_enable is at an inactive level, the output terminal of the first selection circuit 1311 outputs a termination resistance control code ODT or an inverted signal of the termination resistance control code ODT to the pull-up drive circuit.

The resistance control circuit 130 includes a pull-down resistance control circuit, and the pull-down resistance control circuit includes a second selection circuit 1321. The second selection circuit 1321 is configured to receive a termination resistance control code ODT, an output drive resistance control code RON, and a read enable signal Read _enable. When the read enable signal Read_enable is at an active level, an output terminal of the second selection circuit 1321 outputs an output drive resistance control code RON or an inverted signal RONB of the output drive resistance control code RON to the pull-down drive circuit. When the read enable signal is at an inactive level, the output terminal of the second selection circuit outputs an inactive level to the pull-down drive circuit. In an embodiment of a pull-down drive circuit including an NMOS transistor, an inactive level may be a low level, so that the pull-down drive circuit including the NMOS transistor is not turned on, an output of the pull-down drive circuit is in a floating state, and a high-impedance state is output.

FIG. 9 shows a schematic diagram of a circuit structure of a second selection circuit 1321. The second selection circuit 1321 may include an eighth NAND gate NAND8, a ninth NAND gate NAND9, and a tenth NAND gate NAND10. A first input terminal of the eighth NAND gate NAND8 receives a read enable signal Read_enable through a transmission gate, and a second input terminal of the eighth NAND gate NAND8 receives an output drive resistance control code RON or an inverted signal RONB of the output drive resistance control code RON. A first input terminal of the ninth NAND gate NAND9 receives an inverted signal of the read enable signal Read_enable, and a second input terminal of the ninth NAND gate NAND9 receives an inactive level (in some embodiments, the inactive level may be a low level Vss). Two input terminals of the tenth NAND gate NAND10 are respectively connected to an output terminal of the eighth NAND gate NAND8 and an output terminal of the ninth NAND gate NAND9, and an output terminal of the tenth NAND gate NAND10 is taken as an output terminal of the second selection circuit 1321, and outputs a signal RON_PD_CTL.

In some other embodiments, for a memory with pull-down termination, the memory may be set in a manner opposite to that described above. A signal input to the termination resistance code ODT corresponding to a selection circuit of a pull-up drive circuit is at an inactive level, and a signal input to the termination resistance code ODT corresponding to the pull-down drive circuit is a code value of ODT.

As shown in FIG. 2, the output drive circuit includes pre-drive circuits 141 and 142 and main drive circuits 143 and 144. The pre-drive circuit includes a pull-up pre-drive circuit 141 and a pull-down pre-drive circuit 142. The main drive circuit includes a pull-up main drive circuit 143 and a pull-down main drive circuit 144. The pull-up pre-drive circuit 141 is connected to the parallel-to-serial conversion circuit 110 and the pull-up resistance control circuit 131, and receives a data signal DATA and a control code output by the pull-up resistance control circuit 131. The pull-down pre-drive circuit 142 is connected to the parallel-to-serial conversion circuit 110 and the pull-down resistance control circuit 132, and receives a data signal DATA and a signal output by the pull-down resistance control circuit 132. The pull-up main drive circuit 143 is connected to the pull-up pre-drive circuit 141, and receives a pre-drive signal PU output by the pull-up pre-drive circuit 141. The pull-down main drive circuit 144 is connected to the pull-down pre-drive circuit 142, and receives a pre-drive signal PD output by the pull-down pre-drive circuit 142.

The pre-drive circuits 141 and 142 each include a second AND logic circuit. A first input terminal of the second AND logic circuit serially receives N pieces of data DATA, and a second input terminal of the second AND logic circuit receives a signal (RON_ODT_CTL or RON_PD_CTL) output by the resistance control circuit. The second AND logic circuit performs NAND logic processing on a signal received at the first input terminal and the signal received at the second input terminal, and then outputs a signal. The main drive circuit 143 includes a PMOS transistor electrically connected between a power supply voltage Vdd and an output port DQ, and a control terminal of the PMOS transistor receives the signal output by the second AND logic circuit. Alternatively, the second AND logic circuit performs AND logic processing on a signal received at the first input terminal and the signal received at the second input terminal, and then outputs a signal. The main drive circuit 144 includes an NMOS transistor electrically connected between a power supply voltage Vss and the output port DQ, and a control terminal of the NMOS transistor receives the signal output by the second AND logic circuit.

Specifically, referring to FIG. 10, FIG. 10 is a schematic structural diagram of a pull-up pre-drive circuit according to an embodiment of the present disclosure. The pull-up pre-drive circuit includes multiple second AND logic circuits 1411. A first input terminal of the second AND logic circuit 1411 serially receives N pieces of data (DATA), and a second input terminal of the second AND logic circuit 1411 receives one bit of a control code RON_ODT_CTL output by the pull-up resistance control circuit 131 (such as RON_ODT_CTL0 in 1411, indicating a lowest bit of the control code RON_ODT_CTL output by the pull-up resistance control circuit 131). After performing NAND logic processing on the signal received at the first input terminal and the signal received at the second input terminal, the second AND logic circuit 1411 drives an obtained signal through an even number of inverters shown in FIG. 10, and then outputs a pull-up data signal (a lowest bit PU_0 that is used to drive the pull-up data signal in FIG. 10) to the pull-up main drive circuit 143. In some embodiments, after performing NAND logic processing on the signal received at the first input terminal and the signal received at the second input terminal, the second AND logic circuit 1411 may also directly output the pull-up data signal PU_0 without passing through an even number of inverters.

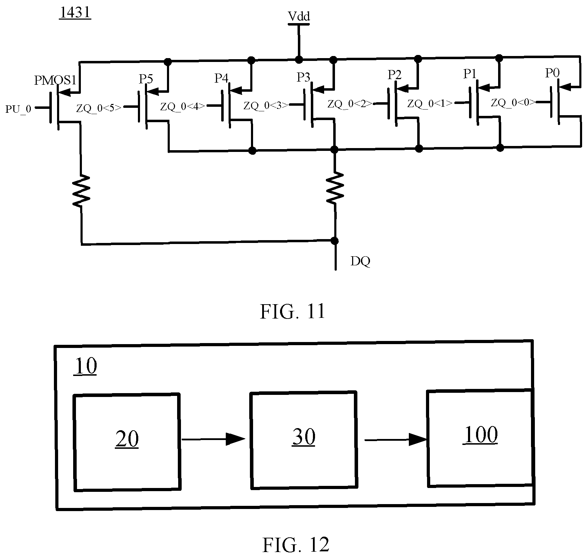

The pull-up main drive circuit 143 includes multiple sub-pull-up main drive circuits. FIG. 11 is a schematic structural diagram of a first sub-pull-up main drive circuit according to an embodiment of the present disclosure. As shown in FIG. 11, the first sub-pull-up main drive circuit 1431 includes a PMOS transistor electrically connected between a power supply voltage Vdd (a high-level power supply voltage) and an output port DQ, and a control terminal of the PMOS transistor receives a data signal PU_0 output by a second AND logic circuit.

Referring to FIG. 10, the second AND logic circuit 1411 further performs AND logic processing on the serial data signal DATA and the signal RON_ODT_CTL0 output by the pull-up resistance control circuit 131, and performs NAND logic processing on an AND logic processing result and a ZQ calibration code ZQ_CODE<5:0> for calibrating a ZQ resistor of the main drive circuit to obtain a processed ZQ calibration code ZQ_0<5:0>. The calibrated ZQ calibration code ZQ_0<5:0> is sent to the main drive circuit for calibrating the ZQ resistor of the main drive circuit. By performing NAND logic processing on the ZQ calibration code and the signal RON_ODT_CTL output by the pull-up resistance control circuit 131, the ZQ calibration code carries timing information of a read operation and a non-read operation, so that a ZQ resistance path of the main drive circuit can be closed during the read operation, thereby reducing power consumption.

Referring to FIG. 11, the first sub-pull-up main drive circuit 1431 includes a data output path (a path where a PMOS1 transistor is located) and a ZQ resistance path (a path where P0-P5 transistors are located). The data output path is configured to receive the pull-up data signal PU_0 output by the pre-drive circuit, and output data. The ZQ resistance path receives the processed ZQ calibration code ZQ_0<5:0>, and is configured to adjust a resistance of the first sub-pull-up main drive circuit 1431, so that a resistance value of the first sub-pull-up main drive circuit 1431 is 240 ohms. Both the data output path and the ZQ resistance path have resistances, which are used to adjust linearity of the path.

A second AND logic circuit 1411 is configured to drive a corresponding first sub-pull-up main drive circuit 1431. In some embodiments, the pull-up pre-drive circuit 141 includes seven second AND logic circuits, the pull-up main drive circuit 143 includes seven sub-pull-up main drive circuits, and the seven second AND logic circuits are in a one-to-one correspondence with the seven sub-pull-up main drive circuits.

According to the foregoing design of the pull-up drive circuits 141 and 143, when the memory enters a state where data is read, the output signal RON_ODT_CTL of the resistance control circuit is a pull-up output drive resistance control code Pu_Ron, and a path of the pull-up drive circuit is controlled through a control codeword of the pull-up output drive resistance control code Pu_Ron. When Pu_Ron=0, an output of the pull-up pre-drive circuit is a high level, and an output of the pull-up drive circuit is a high-impedance state. When Pu_Ron=1, the output of the pull-up drive circuit is a data signal DATA. When the memory enters a non-read state (such as a termination resistance ODT state), the output signal RON_ODT_CTL of the resistance control circuit is a termination resistance control code ODT. In this case, the output of the parallel-to-serial conversion circuit is a default value "1". When the termination resistance control codeword ODT is equal to 1, the output of the pull-up pre-drive circuit is 0, and the corresponding pull-up main drive circuit is turned on to act as a pull-up resistor. When the termination resistance control codeword ODT is equal to 0, the output of the pull-up pre-drive circuit is 1, and the pull-up main drive circuit outputs a high-impedance state.

Therefore, the pull-up pre-drive circuit can send the data to the pull-up main drive circuit without bias, and then the pull-up main drive circuit outputs the data. When the data is "0", the pull-up main drive circuit is turned on. When the data is "1", the pull-up main drive circuit is turned off. Because the pull-up pre-drive circuit combines with an output signal of the resistance control circuit, a data transmission process of the pull-up pre-drive circuit includes timing of a read operation and a non-read operation, and an output drive resistance value may be automatically set or a termination resistance value may be configured while data is transmitted. When the output signal (control code) of the resistance control circuit is "1", the data output by the parallel-to-serial conversion circuit can be transferred to the pull-up main drive circuit through the pull-up pre-drive circuit. On the contrary, if the output signal (control code) of the resistance control circuit is "0", the data output by the parallel-to-serial conversion circuit is ignored, and the pull-up main drive circuit is directly turned off. Further, by combining the parallel-to-serial conversion circuit, the pull-up pre-drive circuit, and the output signal (control code) of the resistance control circuit, in a read process, an output function can be implemented through one parallel-to-serial conversion circuit that is connected to the pull-up output drive circuit and the pull-down output drive circuit, and only one read enable signal Read_enable is used, thereby reducing tADC deviation.

For the pull-down pre-drive circuit and the pull-down main drive circuit, circuit structures corresponding to FIG. 10 and FIG. 11 may also be used. For example, the pull-down pre-drive circuit may include a second AND logic circuit, a first input terminal of the second AND logic circuit serially receives N pieces of data (DATA), and a second input terminal of the second AND logic circuit receives one bit of a control code RON_PD_CTL output by the pull-down resistance control circuit 132. The second AND logic circuit performs AND logic processing on the signal received at the first input terminal and the signal received at the second input terminal, and then outputs a signal to the pull-down main drive circuit 144. The pull-down main drive circuit 144 includes multiple sub-pull-down main drive circuits, and each of the sub-pull-down main drive circuits includes a data output path including an NMOS transistor and a ZQ resistance path. Specifically, the sub-pull-down main drive circuit includes an NMOS transistor electrically connected between the power supply voltage Vss (low-level power supply voltage D) and the output port DQ, and a resistor configured to improve linearity. A control terminal of the NMOS transistor of the data output path receives a signal output by the second AND logic circuit, and a control terminal of the NMOS transistor of the ZQ resistance path receives the processed ZQ calibration code.

In some other embodiments, the NAND gate in the pull-up pre-drive circuit in FIG. 10 may be replaced with NOR gate processing logic. In this case, the input control code RON_PD_CTL may be an inverted signal of the output signal in FIG. 7.

As shown in FIG. 2, the pull-up drive circuits 141 and 143 are connected to an output terminal of the parallel-to-serial conversion circuit 110, and receive N pieces of data DATA in a first time period T1. The pull-down drive circuits 142 and 144 are connected to the output terminal of the parallel-to-serial conversion circuit 110, and receive the N pieces of data DATA in the first time period T1. The pull-up drive circuits 141 and 143 are configured to output a high level among the N pieces of data in the first time period T1, and configure an output drive resistance value based on the output drive resistance control code RON. The pull-down drive circuits 142 and 144 are configured to output a low level among the N pieces of data DATA in the first time period, and configure an output drive resistance value based on the output drive resistance control code ODT. The pull-up drive circuit is further configured to configure a termination resistance value outside the first time period T1.

Therefore, the pull-up drive circuit and the pull-down drive circuit are connected to a same parallel-to-serial conversion circuit to output data, and an output drive resistance value may be configured during a read operation, and a termination resistance value is configured during a non-read operation.

Embodiments of the present disclosure further provide a memory. FIG. 12 is a schematic structural diagram of a memory according to an embodiment of the present disclosure. As shown in FIG. 12, the memory 10 includes the input/output circuit 100 described in any one of the foregoing embodiments, the memory 10 further includes a storage array 20 and a data transmission circuit 30, and the storage array 20 includes multiple storage units, configured to store data. The data transmission circuit 30 is configured to perform various processing and transmission on data when data is written or read. When a read operation is performed on the memory 10, the data DATA is read from the storage array 20, transmitted by the data transmission circuit 30, and then output from the data input/output circuit 100.

A person of ordinary skill in the art may understand that the foregoing implementations are specific embodiments for implementing this application. In actual application, various modifications may be made to the forms and details of the implementations without departing from the spirit and scope of this application. Any person skilled in the art may make changes and modifications without departing from the spirit and scope of this application. Therefore, the protection scope of this application shall be subject to the scope defined by the claims.

## Claims

1. A data input/output circuit, comprising a parallel-to-serial conversion circuit, a read enable signal generation circuit, a resistance control circuit, and an output drive circuit, wherein
the parallel-to-serial conversion circuit is configured to receive N pieces of data, and serially output the N pieces of data in a first time period;
the read enable signal generation circuit is configured to generate a read enable signal, and the read enable signal is at an active level in the first time period;
the resistance control circuit is electrically connected to the read enable signal generation circuit, and is configured to receive a termination resistance control code, an output drive resistance control code, and the read enable signal, and choose, based on the read enable signal, to output the termination resistance control code or output the output drive resistance control code; and
the output drive circuit is electrically connected to the parallel-to-serial conversion circuit and the resistance control circuit, and is configured to receive the N pieces of data and a signal output by the resistance control circuit, configure an output drive resistance value based on the signal output by the resistance control circuit and output the N pieces of data, or configure a termination resistance value,
wherein N is a positive integer greater than 1.

2. The data input/output circuit according to claim 1, wherein the output drive circuit comprises a pull-up drive circuit and a pull-down drive circuit, and the parallel-to-serial conversion circuit is connected to the pull-up drive circuit and the pull-down drive circuit, and outputs the N pieces of data to the pull-up drive circuit and the pull-down drive circuit.

3. The data input/output circuit according to claim 1 or 2, wherein the parallel-to-serial conversion circuit comprises a first data input port, a second data input port, a third data input port, and a fourth data input port, and the parallel-to-serial conversion circuit receives the N pieces of data through the first to fourth data input ports; and the parallel-to-serial conversion circuit further receives a first clock, a second clock, a third clock, and a fourth clock, samples the N pieces of data based on the first to fourth clocks, and serially outputs the N pieces of data in the first time period;
the first time period comprises a second time period, a third time period, and a fourth time period, the second time period is earlier than the third time period, and the third time period is earlier than the fourth time period; and the parallel-to-serial conversion circuit is further configured to fixedly output a first level in the second time period and the fourth time period, and serially output the N pieces of data in the third time period; and
clock frequencies of the first clock, the second clock, the third clock, and the fourth clock are the same, and phase differences sequentially differ by one quarter of a cycle; and N is a positive integer multiple of 4.

4. The data input/output circuit according to claim 3, wherein the parallel-to-serial conversion circuit comprises a first sampling circuit, a second sampling circuit, and a first NAND gate; a first input terminal of the first sampling circuit receives the first clock, and a second input terminal of the first sampling circuit is connected to the first data input port, and samples, through the first clock, data input by the first data input port; a first input terminal of the second sampling circuit receives the second clock, and a second input terminal of the second sampling circuit receives a second level, and samples the second level through the second clock; and a first input terminal of the first NAND gate is connected to an output terminal of the first sampling circuit, a second input terminal of the first NAND gate is connected to an output terminal of the second sampling circuit, and the first NAND gate outputs a first sampling result;
the parallel-to-serial conversion circuit further comprises a third sampling circuit, a fourth sampling circuit, and a second NAND gate; a first input terminal of the third sampling circuit receives the third clock, and a second input terminal of the third sampling circuit is connected to the third data input port, and samples, through the third clock, data input by the third data input port; a first input terminal of the fourth sampling circuit receives the fourth clock, and a second input terminal of the fourth sampling circuit receives the second level, and samples the second level through the fourth clock; and a first input terminal of the second NAND gate is connected to an output terminal of the third sampling circuit, a second input terminal of the second NAND gate is connected to an output terminal of the fourth sampling circuit, and the second NAND gate outputs a third sampling result;
the parallel-to-serial conversion circuit further comprises a fifth sampling circuit, a sixth sampling circuit, and a third NAND gate; a first input terminal of the fifth sampling circuit receives the second clock, and a second input terminal of the fifth sampling circuit is connected to the second data input port, and samples, through the second clock, data input by the second data input port; a first input terminal of the sixth sampling circuit receives the third clock, and a second input terminal of the sixth sampling circuit receives the second level, and samples the second level through the third clock; and a first input terminal of the third NAND gate is connected to an output terminal of the fifth sampling circuit, a second input terminal of the third NAND gate is connected to an output terminal of the sixth sampling circuit, and the third NAND gate outputs a second sampling result;
the parallel-to-serial conversion circuit further comprises a seventh sampling circuit, an eighth sampling circuit, and a fourth NAND gate; a first input terminal of the seventh sampling circuit receives the fourth clock, and a second input terminal of the seventh sampling circuit is connected to the fourth data input port, and samples, through the fourth clock, data input by the fourth data input port; a first input terminal of the eighth sampling circuit receives the first clock, and a second input terminal of the eighth sampling circuit receives the second level, and samples the second level through the first clock; and a first input terminal of the fourth NAND gate is connected to an output terminal of the seventh sampling circuit, a second input terminal of the fourth NAND gate is connected to an output terminal of the eighth sampling circuit, and the fourth NAND gate outputs a fourth sampling result; and
a first AND logic circuit is connected to the first to fourth NAND gates, receives the first to fourth sampling results, and performs first AND logic processing on the first to fourth sampling results, so as to output the first level in the second time period and the fourth time period, and serially output the N pieces of data in the third time period.

5. The data input/output circuit according to claim 1 or 2, wherein the resistance control circuit comprises a first selection circuit, and the first selection circuit is configured to receive a termination resistance control code, an output drive resistance control code, and the read enable signal; when the read enable signal is at an active level, an output terminal of the first selection circuit outputs the output drive resistance control code or an inverted signal of the output drive resistance control code; and when the read enable signal is at an inactive level, the output terminal of the first selection circuit outputs the termination resistance control code.

6. The data input/output circuit according to claim 5, wherein the first selection circuit comprises a fifth NAND gate, a sixth NAND gate, and a seventh NAND gate; a first input terminal of the fifth NAND gate receives the read enable signal, and a second input terminal of the fifth NAND gate receives the output drive resistance control code or the inverted signal of the output drive resistance control code; a first input terminal of the sixth NAND gate receives an inverted signal of the read enable signal, and a second input terminal of the sixth NAND gate receives the termination resistance control code; and two input terminals of the seventh NAND gate are respectively connected to an output terminal of the fifth NAND gate and an output terminal of the sixth NAND gate, and an output terminal of the seventh NAND gate is taken as the output terminal of the first selection circuit.

7. The data input/output circuit according to claim 2, wherein the resistance control circuit comprises a first selection circuit, and the first selection circuit is configured to receive a termination resistance control code, an output drive resistance control code, and the read enable signal; when the read enable signal is at an active level, an output terminal of the first selection circuit outputs the output drive resistance control code or an inverted signal of the output drive resistance control code to the pull-up drive circuit; and when the read enable signal is at an inactive level, the output terminal of the first selection circuit outputs the termination resistance control code or an inverted signal of the termination resistance control code to the pull-up drive circuit; and
the resistance control circuit further comprises a second selection circuit, and the second selection circuit is configured to receive an inactive level, an output drive resistance control code, and the read enable signal; when the read enable signal is at an active level, an output terminal of the second selection circuit outputs the output drive resistance control code or an inverted signal of the output drive resistance control code to the pull-down drive circuit; and when the read enable signal is at an inactive level, the output terminal of the second selection circuit outputs the inactive level to the pull-down drive circuit.

8. The data input/output circuit according to claim 1 or 2, wherein the output drive circuit comprises a pre-drive circuit and a main drive circuit, the pre-drive circuit comprises a second AND logic circuit, a first input terminal of the second AND logic circuit receives the N pieces of data, and a second input terminal of the second AND logic circuit receives a signal output by the resistance control circuit;
the second AND logic circuit performs NAND logic processing on a signal received at the first input terminal and the signal received at the second input terminal, and then outputs a signal, the main drive circuit comprises a PMOS transistor electrically connected between a power supply voltage and an output port, and a control terminal of the PMOS transistor receives the signal output by the second AND logic circuit; or
the second AND logic circuit performs AND logic processing on a signal received at the first input terminal and the signal received at the second input terminal, and then outputs a signal, the main drive circuit comprises an NMOS transistor electrically connected between a power supply voltage and an output port, and a control terminal of the NMOS transistor receives the signal output by the second AND logic circuit.

9. The data input/output circuit according to claim 2, wherein the pull-up drive circuit is connected to an output terminal of the parallel-to-serial conversion circuit, and receives the N pieces of data in the first time period; and the pull-down drive circuit is connected to the output terminal of the parallel-to-serial conversion circuit, and receives the N pieces of data in the first time period;
the pull-up drive circuit is configured to output a high level among the N pieces of data in the first time period, and configure an output drive resistance value based on the output drive resistance control code; and the pull-down drive circuit is configured to output a low level among the N pieces of data in the first time period, and configure an output drive resistance value based on the output drive resistance control code; and
the pull-up drive circuit is further configured to configure a termination resistance value outside the first time period.

10. A memory, wherein the memory comprises the data input/output circuit according to any one of claims 1 to 9, the memory further comprises a storage array and a data transmission circuit, and the storage array stores data; and
when a read operation is performed on the memory, data is read from the storage array, transmitted by the data transmission circuit, and then output from the data input/output circuit.
